(19) **Europäisches Patentamt European Patent Office Office européen des brevets**

(11) **EP 4 625 825 A1**

(12) **EUROPEAN PATENT APPLICATION**

(43) Date of publication:
01.10.2025 Bulletin 2025/40

(21) Application number: 24305470.7

(22) Date of filing: 28.03.2024

(51) International Patent Classification (IPC):
H03M 1/60 (2006.01)        H03M 3/00 (2006.01)
H03M 1/06 (2006.01)

(52) Cooperative Patent Classification (CPC):
H03M 1/60; H03M 1/0626; H03M 3/39

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(71) Applicant: Presto Engineering Group
13590 Meyreuil (FR)

(72) Inventors:
• RASMUSSEN, Erik Elmer
  Copenhagen S (DK)
• ESTRUP, George
  2800 Kgs. Lyngby (DK)
• SUANES-PEREZ, Alejandro
  Almería 04878 (ES)
• SERRA-GRAELLS, Francesc
  08193 Cerdanyola del Vallès (ES)

(74) Representative: Germain Maureau
12, rue Boileau
69006 Lyon (FR)

(54) **ANALOG TO DIGITAL CONVERTER WITH LOW-FREQUENCY NOISE CANCELLATION**

(57)      The present disclosure relates to a method for converting an input analog signal into an output digital value, the method comprising, during an integration phase: applying an input analog signal (Ic) to an input of an integrator (OP1-CI) comprising an integration capacitor (CI) connected between the input and an output of the integrator; submitting a reset capacitor (CR) to a first reference voltage (Vth); each time a voltage (Vi) of the integrator output reaches a second reference voltage (Vrf-Vth), generating an event in an event signal (EVT), submit the reset capacitor to a noise signal (Vn1) generated by the integrator coupling the integration capacitor to the reset capacitor to reset the charge of the integration capacitor; and counting the generated events in the event signal during the integration phase to obtain a digital value (DO) corresponding to the input analog signal.

Fig. 4

**Description**

**TECHNICAL FIELD**

The present disclosure relates to measurement of analog signals and more specifically to measurement of currents issued from a sensor by converting such currents into digital samples. The present disclosure relates to the field of analog to digital converters (ADC) and more specifically to integrating ADCs. Integrating ADCs are generally used in applications where a high resolution is required at a comparatively low sample rate.

**BACKGROUND**

At present, there are many varieties of ADC, such as sigma-delta ADC, feedback type ADC, slope or integrating ADC, flash ADC, pipeline ADC and successive approximation register (SAR) ADC. Sigma-delta ADCs have generally a high resolution but are not suitable for high frequency signals and have a high complexity and current consumption. Feedback type and slope and charge redistribution ADCs have generally a low complexity and power consumption and can process medium frequency signals but have a medium resolution. Flash ADCs can process high frequency signals with a low resolution, but have a high complexity and high power consumption.

The present disclosure more specifically relates to a type of slope ADCs operating as a current to frequency converter using the integrate and fire principle. Such an ADC comprises an integrator with an integration capacitor and an integration clock controlling the overall conversion process. After a reset where an integration voltage is set to a reference voltage, an integration starts whereas the integration voltage decreases until it reaches a threshold voltage defined by a comparator which then triggers an event which is counted. The conversion process stops when the time elapsed from the reset time reaches an integration time. As being compact, this type of ADCs is frequently used in pixel circuits of imagers.

However, it turns out that integrator appears to be unneglectable noise source that affects the accuracy of the analog-to-digital conversion.

Thus, there is a need for improving the accuracy of a slope ADC. More specifically, there is a need to reduce the noise that can be generated within such converter.

**SUMMARY**

The present disclosure is related to a method for converting an input analog signal into an output digital value, the method comprising, during an integration phase: applying an input analog signal to an input of an integrator comprising an integration capacitor connected between the input and an output of the integrator; submitting a reset capacitor to a first reference voltage; each time a voltage of the integrator output reaches a second reference voltage, triggering a reset period from which an event in an event signal is generated, the integration capacitor is coupled to the reset capacitor to reset the charge of the integration capacitor and the reset capacitor is submitted to a noise signal generated by the integrator; and counting the generated events in the event signal during the integration phase to obtain a digital value corresponding to the input analog signal.

Thanks to these provisions, the charge accumulated in the reset capacitor depends on the noise signal generated by the integrator. As a result, the reset capacitor is completely discharged when it is coupled to the integration capacitor during the reset periods. Therefore, the integration of this noise signal in the reset capacitor enables to remove an extra noise contribution from the integrator in the result of the conversion. Thus the precision of the analog-to-digital conversion is improved.

According to an embodiment, the reset capacitor is submitted to the first reference voltage by coupling a first terminal of the reset capacitor to the second reference voltage, a second terminal of the reset capacitor being connected to an output and a first input of an operational amplifier, a third reference voltage being provided to a second input of the first operational amplifier.

According to an embodiment, the reset capacitor is coupled to the integration capacitor by coupling a first terminal of the reset capacitor and a second input of an operational amplifier to a first terminal of the integration capacitor and to the input of the integrator, a second terminal of the reset capacitor being connected to an output and a first input of the operational amplifier

In this manner, the reset capacitor submitted twice to the noise signal generated by the operational amplifier during each reset period. Thus the influence of this noise signal in the digital output signal of the converter is almost

According to an embodiment, a comparator compares the integrator output voltage to the second reference voltage and generates an event in the event signal each time the integrator output voltage reaches the second reference voltage, and a counter counts the events in the event signal.

According to an embodiment, the method further comprises: generating a first control signal controlling a first pair of switches for submitting the reset capacitor to a first reference voltage and a noise signal; and generating a second control signal controlling a second pair of switches for coupling the integration capacitor to the reset capacitor to reset the charge of the integration capacitor, the first and second control signals being generated so as to have different logical states.

According to an embodiment, the method further comprises: at the end of the integration period, continuing to apply the input analog signal to the integrator, to couple the integration capacitor to the reset capacitor and to generate an event in the event signal, each time the output voltage of the integrator reaches the second reference voltage; determining a residual time from a last event in the event signal to the end of the integration period; and determining an output digital value corresponding to the input analog signal as a function of the event count value, the residual time and an event period.

In this manner, the digital value provided by the analog-to-digital conversion has a higher resolution. In addition, the residual charge in the integration capacitor can be measured without using complex circuits including capacitors.

According to an embodiment: the residual time is measured by a counter providing a residual time count, or the residual time is determined by measuring a time from the end of the integration period to a time when the integrator voltage reaches the reference voltage, and by subtracting the measured time from a measured event period to obtain a residual time count.

According to an embodiment, the event period is measured between first and second consecutive events generated when the integrator voltage reaches the reference voltage after the end of the integration period.

According to an embodiment, the output digital value corresponding to the input analog signal is determined from the event count value and a ratio of the residual time count and the measured event period, a least significant bit of the count value having a fractional value equal to the ratio.

Embodiments may also relate to an analog-to-digital converter comprising: an integrator comprising an integrator capacitor connected between an input and an output of the integrator, an input analog signal to be converted being applied to the input of the integrator; a reset capacitor; a comparator configured to compare a voltage of the integrator output to a second reference voltage and to generate an event in an event signal; a counter configured to count the generated events in the event signal during an integration phase to obtain a digital value corresponding to the input analog signal; and a control unit configured to control charge and discharge of the integration capacitor and the reset capacitor according to the method defined above.

According to an embodiment, the integrator comprises an operational amplifier having a first input connected to the input of the integrator, a second input receiving the third reference voltage and an output connected to the output of the integrator.

According to an embodiment, the converter further comprises: an operational amplifier having a first input and an output connected to the first input and to a terminal of the reset capacitor, a second input of the operational amplifier receiving a third reference voltage during the integration periods and being connected to the input of the integrator during the reset periods.

According to an embodiment, the converter further comprises: a first pair of switches configured to submit the reset capacitor to a first reference voltage during the integration periods, the first pair of switches being controlled by a first control signal, a second pair of switches configured, during the reset periods, to submit the reset capacitor to the noise signal generated by the integrator, and to couple the reset capacitor to the integration capacitor, to reset the charge of the integration capacitor, the second pair of switches being controlled by a second control signal, and a logical circuit for generating the first and second control signals such that the first and second control signals have different logical states.

According to an embodiment, the converter further comprises: a converter receiving the event signal and configured to measure a residual time corresponding to a residual charge left in the capacitor of the integrator at the end of the integration phase.

## BRIEF DESCRIPTION OF THE DRAWINGS

The foregoing and other purposes, features, aspects and advantages of the invention will become apparent from the following detailed description of embodiments, given by way of illustration and not limitation, with reference to the accompanying drawings, in which the same reference refer to similar elements or to elements having similar functions, and in which:

Figure 1 is a schematic view of a circuit of a conventional integrate and fire analog-digital converter;

Figure 2 is an operation timing view showing an example of the operation of the analog-digital converter of Figure 1;

Figures 3A and 3B are schematic and simplified views of the circuit of Figure 1, during integration and reset phases, respectively;

Figure 4 is a schematic view of a circuit of an integrate and fire analog-digital converter, according to an embodiment;

Figures 5A and 5B are schematic and simplified views of the circuit of Figure 4, during integration and reset phases, respectively;

Figure 6 is a schematic view of a circuit of an integrate and fire analog-digital converter, according to another embodiment;

Figure 7 is an operation timing view showing an example of the operation of the analog-digital converter of Figure 6, according to an embodiment;

Figure 8 illustrates a concatenation operation of counter values provided by the analog-digital converter of Figure 7 to obtain a final result, according to an embodiment;

Figure 9 is a schematic view of a circuit of the analog-digital converter of Figure 6, according to another embodiment;

Figure 10 is an operation timing view showing an example of the operation of the analog-digital converter of Figure 9, according to an embodiment.

## DETAILED DESCRIPTION

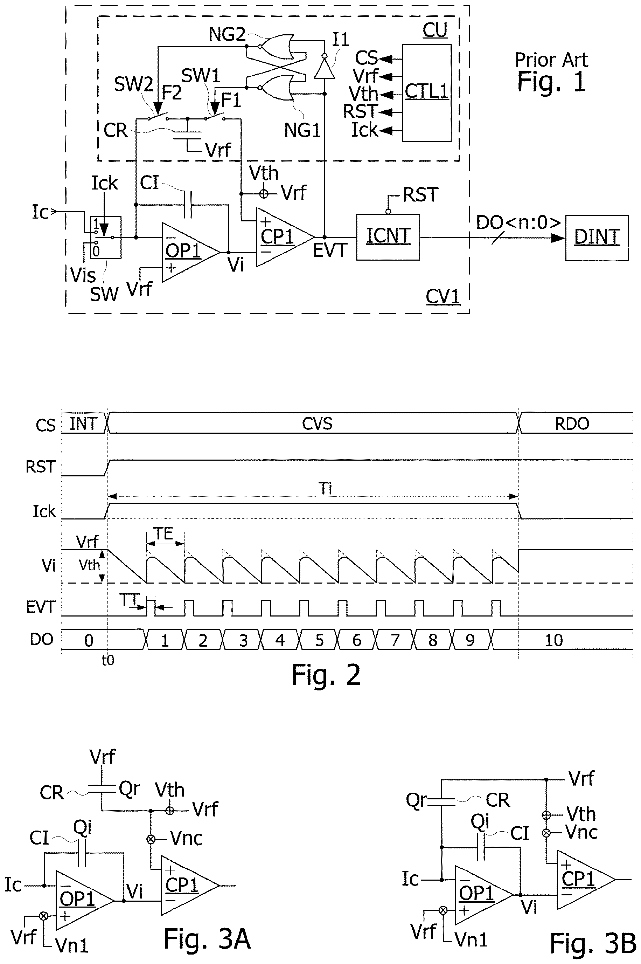

Figure 1 shows a conventional integrate and fire analog-digital converter (ADC) CV1. The ADC CV1 comprises an integrator comprising an operational amplifier OP1 and an integration capacitor CI, a comparator CP1 and an integration counter ICNT, and a controller CTL1. The operational amplifier OP1 comprises a positive input receiving a positive reference voltage Vrf and a negative input connected to a selector SW for selecting an input current Ic or a reference voltage Vis. The integration capacitor CI is connected between the negative input and an output of the operational amplifier OP1. The output of the operational amplifier OP1 is connected to a negative input of the comparator CP1. The comparator CP1 comprises a positive input receiving a positive reference voltage Vrf-Vth. The comparator CP1 provides an event signal to the counter ICNT. The counter ICNT is set to 0 by a reset signal RST and provides a digital output signal DO to a digital interface DINT. The ADC CV1 further comprises a control circuit CU comprising a reset capacitor CR, switches SW1, SW2, a controller CTL1 and logical gates I1, NG1, NG2. The reset capacitor CR is connected to the ground or the reference voltage source Vrf, linked to the positive input of the comparator CP1 by the switch SW1, and linked to the negative input of the operational amplifier OP1 by the switch SW2. The switches SW1 and SW2 are controlled by respective control signals F1 and F2 provided by the logical circuit comprising two NOR gates NG1, NG2 connected to form a latch, an inverter I1 having an input connected to an input of the gate NG1 and to the output of the comparator CP1 and an output connected to an input of the gate NG2. The output of the gate NG1 provides the control signal F1 and the output of the gate NG2 provides the control signal F2. Thus when the control signal F1 is switched to a low state, the control signal F2 is switched to a high state a few nanoseconds after and reversely. Thus the switches SW1, SW2 are controlled such that they are never in the closed state at the same time, to avoid charge sharing issues. When the signal EVT is in a low state, the control signals F1, F2 are respectively in high and low states. When the signal EVT is in a high state, the control signals F1, F2 are respectively in low and high states.

The controller CTL1 can comprise a finite state machine to provide a control signal defining operating phases of the ADC, the voltages Vrf, Vth and the signals RST, Ick during each operating phase of the ADC.

Figure 2 illustrates the operation of the ADC CV1. Figure 2 shows a control signal CS that controls the ADC, the reset signal RST, the clock signal Ick, the output voltage Vi of the operational amplifier OP1, the output signal EVT of the comparator CP1 and the output data DO of the counter ICNT. The control signal CS provided by the controller CTL1 defines an initialization phase INT, an integration phase CVS and reading phase RDO. The duration of the integration phase CVS corresponds to an integration time Ti. During the initialization phase INT, the reset signal RST and the clock signal Ick are set to a low state. The output voltage Vi is set to the reference voltage Vrf using a switch (not shown) to short the integration capacitor CI. The digital output signal IA is set to 0.

The integration phase CVS is triggered by setting the reset signal RST and the clock signal Ick to a high state. Thus the selector SW is set to provide the input signal Ic to the negative input of the operational amplifier OP1. During a first integration period, the output voltage Vi of the operational amplifier OP1 follows a decreasing slope until it reaches the reference voltage Vrf-Vth. At this time, a reset period is triggered, in which a pulse appears in the output signal EVT of the comparator CP1, the digital output signal DO is set to 1, and a reset of the integration capacitor CI is performed, setting the output voltage Vi to a voltage near the reference voltage Vrf. During a subsequent integration period, the output voltage Vi increases and then follows the decreasing slope until it reaches the reference voltage Vrf-Vth. At this time, a reset period is triggered, in which a new reset of the integration capacitor CI is triggered and a new pulse appears in the output signal EVT, the digital output signal DO is set to 2, and the output voltage Vi follows the same curve as when it reaches the reference voltage Vrf-Vth for the first time. The decreasing slope in the signal Vi, during each integration period, is determined by the input current Ic, a larger current meaning a faster discharge and thus steeper slope. TE represents the time interval between two consecutive events (or pulses) in the EVT signal during the integration period Ti. The time interval TE depends on the input signal Ic.

The reset capacitor CR and the controlled switches SW1, SW2 enable to perform a soft reset for discharging the capacitor CI (when the output voltage Vi jumps to a voltage near the reference voltage Vrf. A hard reset consisting in shorting the capacitor CI would interrupt the integration for a brief moment and would introduce a large nonlinearity. The capacitor CR has a same capacity C as the capacitor CI. When the switch SW1 is closed and the switch SW2 is opened, the capacitor CR is precharged with a charge equal to C*Vth. The capacitor CI receives the same charge when the soft reset is triggered. At this time, the charge of the capacitor CI is equal to C*Vth, the switch SW2 is closed and the switch SW1 is opened, so that the charge in the capacitor CR is moved to the capacitor CI with a negative sign to discharge the latter. Thus the charge of the capacitor CI at the end of a soft reset is equal to the current charge of the capacitor CI (= C*Vth + Ic*TS) minus the current charge of the capacitor CR (= C*Vth), TS being the duration of a soft reset operation. Thus, the soft resets do not stop the integration.

The readout phase RDO starts at the end of the integration phase. During the readout phase RDO, the reading of the value of the counter ICNT is open. The clock signal Ick is set to low, setting the output signal Vi to Vrf, and the output signal EVT is set to low.

In the example of Figure 2, ten pulses appear in the signal EVT during the integration phase CVS. Therefore, during the readout phase RDO, the value DO of the counter ICNT is equal to 10.

Figures 3A and 3B are simplified views of the circuit of Figure 1 during an integration period and a soft reset, respectively. Figures 3A and 3B show noise sources Vn1 and Vnc at the positive inputs of the operational amplifier OP1 and the comparator CP1, respectively. During the integration periods (figure 3A) and thanks to the control signals F1 and F2 closing the switch SW1 and opening the switch SW2, the integration capacitor CI receives a charge Qi, and the reset capacitor CR receives a charge Qr as being subjected to the voltage -Vth (= Vrf -Vth - Vrf).

During a soft reset (figure 3B) and thanks to the control signals F1 and F2 opening the switch SW1 and closing the switch SW2, the reset capacitor CR is coupled to the integration capacitor CI such that the charge in the capacitor CR is transferred to the capacitor CI.

During the integration phase CVS, the output voltage Vi of the integrator can be expressed as follows:

$$Vi(t) = Vrf + Vn1(t) - \int \frac{Ic}{Ci} dt - \frac{Qi(t_0)}{Ci} = Vrf + Vn1(t) - \frac{Ic}{Ci} t - \frac{Qi(t_0)}{Ci} \qquad (1)$$

where Ci is the capacity of the capacitor CI, and Qi(t0) is the charge of the capacitor CI at time t0 of the beginning of the integration period CVS.

The event period TE[n] at the $n^{th}$ event (or integration period) of the integration phase CVS can be measured as the time interval from the last reset until the voltage Vi reaches the threshold of the comparator CP1:

$$Vi(TE[n]) = Vrf - Vth + Vnc[n] \qquad (2)$$

where Vi(TE[n]) is the output voltage Vi at the end of the $n^{th}$ period TE[n] and Vnc[n] is the noise voltage Vnc at the positive input of the comparator CP1 at the $n^{th}$ period TE[n]. The application of equation (1) to the time TE[n] and equation (2) lead to the following equation:

$$Vrf + Vn1[n] - \frac{Ic}{Ci} TE[n] - \frac{Qi[n-1+\delta]}{Ci} = Vrf - Vth + Vnc[n] \qquad (3)$$

and then:

$$TE[n] = \frac{Ci}{Ic} \left( Vth - Vnc[n] + Vn1[n] - \frac{Qi[n-1+\delta]}{Ci} \right) \qquad (4)$$

where Qi[n-1+$\delta$] is the charge of the capacitor CI at the time n-1+$\delta$, $\delta$ being the relative width of the pulses of the event signal EVT. In other words, $\delta$ for the pulse n is equal to TT/TE, TT being the duration of the pulse n in the signal EVT.

The charges in both capacitors CI and CR at the end of the integration period n are as follows:

$$Qi[n] = Ci(Vth + Vn1[n] - Vnc[n]) \qquad (5)$$

$$Qr[n] = -Cr \cdot Vth \qquad (6)$$

During each soft reset (figure 3B), the charges in the capacitors CI and CR are redistributed, both capacitors being assumed to have a same capacity (Ci = Cr). By applying the law of conservation of charge, it results that:

$$Qi[n+\delta] + Qr[n+\delta] = Qi[n] + Qr[n] \qquad (7)$$

$$Qr[n+\delta] = Cr \cdot Vn1[n+\delta] \qquad (8)$$

$$Qi[n+\delta] = Ci(Vn1[n] - Vn1[n+\delta] - Vnc[n]) \qquad (9)$$

The following equation is obtained by extrapolating equation (9) for Qi[n-1+ $\delta$] and substituting the latter into equation (4).

$$TE[n] = \frac{Vth \cdot Ci}{Ic} \left( 1 - \frac{\overbrace{(Vnc[n]-Vnc[n-1])}^{CDS}}{Vth} + \frac{\overbrace{(Vn1[n]-Vn1[n-1])}^{CDS}}{Vth} + \frac{Vn1[n-1+\delta]}{Vth} \right) \qquad (10)$$

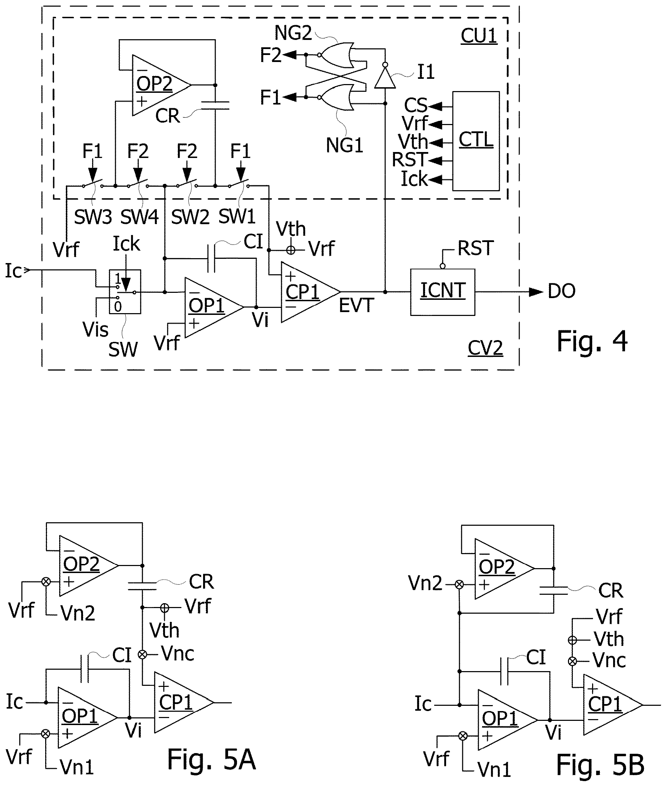

It appears from equation (10) that correlated double sampling (CDS) is performed both for the noise Vnc of the comparator CP1 and partially to the noise Vn1 of the amplifier OP1. The comparator noise Vnc and partially the amplifier noise Vn1 are implicitly cancelled out, provided that they are substantially constant during two consecutive integration periods n-1 and n. However, an extra noise contribution Vn1[n-1+$\delta$] from the amplifier OP1 is not cancelled. The circuit disclosed in figure 4 aims to fix that problem, considering that this extra noise contribution comes from an imperfect discharge of the integration capacitor CI during the reset period. This imperfect discharge is due to a part of noise Vn1 from the amplifier OP1 which accumulates an additional charge in the reset capacitor CR during the reset period and which is not cancelled out by CDS.

Figure 4 shows an ADC CV2 of the type integrate and fire, according to another embodiment. The ADC CV2 differs from the ADC CV1 in that it comprises a control circuit CU1. The control circuit CU1 mainly differs from the control circuit CU of the ADC CV1 in that it further comprises an additional operational amplifier OP2 and additional switches SW3 and SW4. In addition, the capacitor CR is connected between the junction point between the switches SW1 and SW2 and an output and an inverting input of the amplifier OP2. A direct input of the amplifier OP2 is connected to a junction point between the switches SW3 and SW4. The switch SW3 selectively transmit the reference voltage Vrf to the direct input of the amplifier OP2. The switch SW4 selectively connects the direct input of the amplifier OP2 to a junction point of the switches SW4 and SW2, which is connected to the direct input of the amplifier OP1 and to the capacitor CI. The switches SW1 and SW3 are controlled by the signal F1, and the switches SW2 and SW4 are controlled by the signal F2.

Figures 5A and 5B are simplified views of the circuit of Figure 4, during one of the integration periods (figure 5A) and one of the soft resets (figure 5B) occurring during the integration phase CVS. and thanks to the control signal F1 closing the switches SW1 and SW3, the integration capacitor CI receives a charge Qi as being connected between the inverted input and output of the amplifier OP1, and the capacitor CR receives a charge Qr as being connected between the voltage source Vrf and the output of the amplifier OP2. During the reset phase INT (figure 5B) and thanks to the control signal F2 closing the switches SW2 and SW4, the capacitor CR is coupled to the integration capacitor CI such that the charge in the capacitor CR is transferred to the capacitor CI, and the direct input of the amplifier OP2 receives the input signal Ic.

During the integration periods, the output voltage Vi can be expressed as in equation (1). Thus, the event period TE[n] at the n$^{th}$ event can be expressed as in equation (4).

The charges Qi and Qr in both capacitors CI and CR at the end of each integration period n are:

$$Qi[n] = Ci(Vth + Vn1[n] - Vnc[n]) \qquad (11)$$

$$Qr[n] = -Cr(Vth + Vn2[n]) \qquad (12)$$

When considering equations (5), (6) and (11), (12), the charge Qi[n] in the circuit CV2 is the same as the charge Qi[n] in the circuit CV1 at the end of each integration period n. In contrast, Qr[n] in the circuit CV2 further includes a contribution of the noise Vn2 in the amplifier OP2.

At each soft reset, the charge in the capacitors CI and CR is redistributed. Both capacitors are assumed to have a same capacity (Ci = Cr). Equations (8) and (9) become:

$$Qr[n+\delta] = -Cr \cdot Vn2[n+\delta] \qquad (13)$$

$$Qi[n+\delta] = Ci(Vn1[n] + Vn2[n+\delta] - Vn2[n] - Vnc[n]) \qquad (14)$$

When considering equations (8), (9) and (13), (14), only the charge in the capacitor CR is changed, the contribution of the noise signal Vn1 in the integrator at the end of the soft reset (n+δ) being cancelled and replaced by a variation of charge during the soft reset due to the contribution of the noise signal Vn2 in the amplifier OP2. Thus, the amplifier OP2 enables the charge of the capacitor CR to track the noise signal from the integrator or amplifier OP1 during the soft reset periods. In this manner, the capacitor CI can be perfectly discharged at the end of each reset periods.

The following equation is obtained by extrapolating equation (14) for Qi[n-1+ δ] and substituting the latter into equation (4).

$$TE[n] = \frac{Vth \cdot Ci}{Ic} \left( 1 - \frac{\overline{\frac{CDS}{(Vnc[n]-Vnc[n-1])}}}{Vth} + \frac{\overline{\frac{CDS}{(Vn1[n]-Vn1[n-1])}}}{Vth} + \frac{\overline{\frac{CDS}{Vn2[n-1]-Vn2[n-1+\delta]}}}{Vth} \right) \quad (15)$$

The signal function in the form of f(n) - f(n-1) corresponds to a transfer function of a high-pass filter. This means that the low frequency components of the noise signals Vnc, Vn1 and Vn2 are cancelled out. It result that all noise sources Vnc, Vn1, Vn2 implement some form of CDS. The comparator CP1 and the amplifier OP1 implement CDS at the sampling rate TE[n]. Thus there is no aliasing and white noise is not folded back into the band of interest.

The terms Vn2[n-1+δ] and Vn2[n-1 in equation (15) show that the reset capacitor is subjected twice to the noise signal Vn2 from the additional operational amplifier OP2 during each reset period. Thus the noise signal Vn2 is cancelled out, but at a rate higher than the sampling rate because 0< δ <1 in practice. Low frequency noise is removed but white noise is aliased back into the bandwidth of interest, doubling its power.

It should be observed from equation (15) that the noise signals Vc, Vn1, Vn2 from the operational amplifiers OP1, OP2 and the comparator CP1 do not need to be correlated with each other since compensations occurs separately within each noise signal between two successive integration periods n-1 and n which are highly correlated.

Further it can be observed in figure 2 that there is a difference between the output voltage Vi and the reference voltage Vrf-Vth at the end of the integration phase CVS. This difference corresponds to a residual charge left in the integration capacitor CI and which is discarded. This residual charge corresponds to a part of the input signal Ic which is not considered by the analog-digital conversion and represents a quantization error.

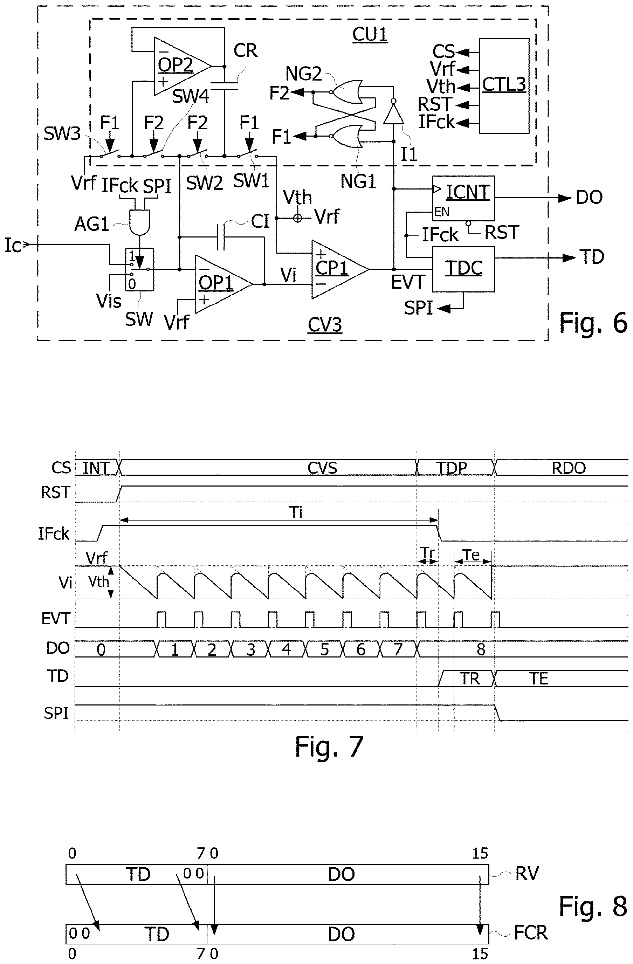

Figure 6 shows an ADC CV3 of the type integrate and fire, according to another embodiment. The ADC CV3 mainly differs from the ADC CV2 in that it further comprises a time to digital converter TDC for converting a time to a digital code to quantize the charge residue left in the integration capacitor CI at the end of the integration phase CVS and a different controller CTL3. The ADC CV3 further comprises an AND gate AG2 receiving signals IFck and SPI and controlling the switch SW. The signal SPI is provided by the circuit TDC. To convert a time to a digital code, the converter TDC uses a high speed clock signal defining its resolution. The converter TDC receives the output signal EVT of the comparator CP1 and a clock signal IFck. The converter TDC provides a count value TD and the signal SPI to stop the integration phase. An AND gate AG2 controls the switch SW, from the clock signal IFck and a signal SPI to stop the integration. Thus, the input signal is provided to the converter CV3 only when both the signals SPI and IFck are in their high state. The controller CTL3 provides the control signal CS defining operating phases of the ADC CV3, the voltages Vrf and Vth, and the signals RST and IFck.

Figure 7 illustrates the operation of the ADC CV3. Figure 7 shows a control signal CS that controls the ADC, the reset signal RST, the clock signal IFck, the output voltage Vi of the operational amplifier OP1, the output signal EVT of the comparator CP1, and the output signals TD and SPI of the converter TDC. The control signal CS defines an initialization phase INT, an integration phase CVS, a conversion phase TDP and a reading phase RDO. During the initialization phase INT the clock signal IFck is set from its low state to its high state. The output voltage Vi is set to the reference voltage Vrf. The reference voltage Vrf-Vth is set to a low voltage and the digital output signals DO and TD are set to 0. The integration period (Ti) starts when the signal RST there is set from a low state to a high state and ends when the clock signal IFck is set to a low state during the conversion phase TDP. The behavior of the ADCs CV3 and CV2 (or CV1) are substantially the same until the end of the integration phase CVS.

In the example of Figure 7, eight events (pulses) appear in the signal EVT during the integration phase CVS. Thus during the readout phase RDO, the value DO of the counter ICNT is 8.

The integration is extended during the conversion phase TDP, to measure the voltage residue of the integration capacitor CI in time domain, but the counter ICNT is disabled. Tr represents the time interval between the last event (pulse) in the EVT signal before the end of the integration period Ti and the end of this period (i.e. the time when the clock signal IFck is set to the low state). The last event period of the integration phase CVS ends during the conversion phase TDP and is followed by another event period extending during a time interval Te. The conversion phase TDP ends at the end of the event period Te and is followed by the readout period TDO. Counting performed by the converter TDC starts at the last event in the EVT signal before the end of the integration period Ti to provide a count TR corresponding to the duration of the time interval Tr and a count TE corresponding to the duration of the time interval Te, i.e. the event period of the signal EVT.

The signal SPI is in the high state during the phases INT, CVS and TDP, and in the low state during the readout phase RDO. The count value TD provided by the converter TDC is equal to TRITE * $2^{TNB}$, TNB being the number of bits of the counter implemented in the converter TDC. The count value TD defines the LSB of the count value DO.

A final result of the converter CV3 can be obtained by shifting right (toward the MSB - Most Significant Bit) the count DO provided by the counter ICNT by the number of bits of the range of the count value TD provided by the converter TDC, and adding to the shifted value the count value TD. The counting performed by the converter TDC to obtain the count value TR can be triggered at each event in the signal EVT, the counter being reset at the beginning of the count.

The converter CV3 presents the advantages of having a low complexity. In addition, no sampling of the input voltage and no calibration are needed. In addition, the converter CV3 can be implemented using the analog part of the hardware of converter CV1.

The time interval Tr can be measured by a counter of the converter TDC, receiving a clock signal of high frequency, which is reset at each event in the event signal EVT and which is stopped at the end of the integration period. Thus at the end of the integration period, the counter provides the count value TR. Then the counter is reset at the next event in the signal EVT and started to count the time interval Te until the subsequent event. At this time the counter contains the count value TE. The value TR can be pushed to a register when the value TE is counted.

Figure 8 illustrates a concatenation operation of the counter values DO and TD provided by the ADC CV3 to obtain a final result, according to an embodiment. Figure 8 shows the raw values RV of the counter values DO and TD. In fact, the counter value TD represents a fraction of the least significant bit (LSB) of the counter value DO. Then, the digital output count DO provided by the counter ICNT is shifted right and added to the count TD that can be provided by the counter TDC to provide a final result FCR. Thus, the resolution of the ADC is increased by the number of effective bits provided by the count TD provided by the counter TDC. In the example of Figure 8, the counter value DO is provided in a 16-bit word, and the counter value TD is provided in an 8-bit word.

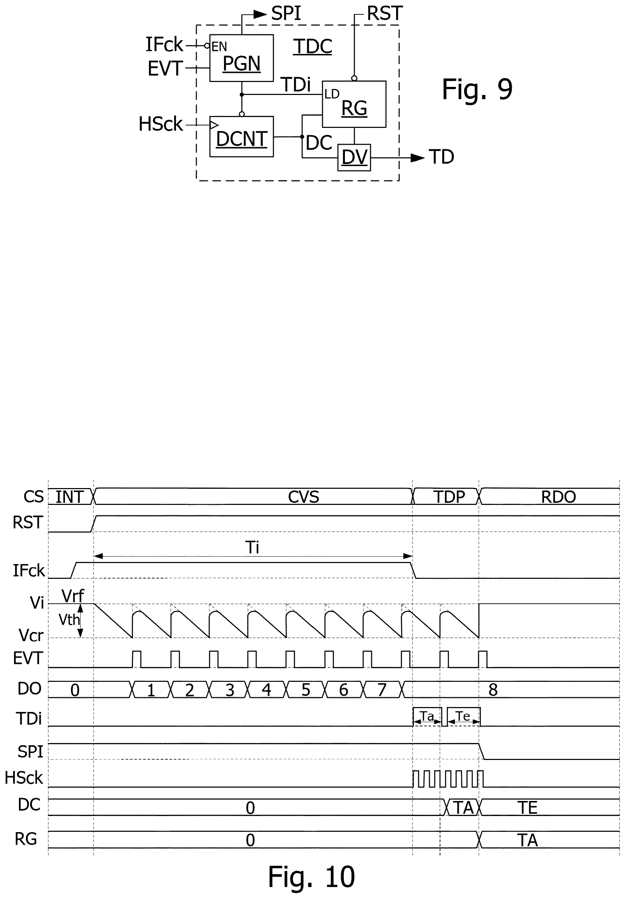

Figure 9 shows an embodiment of the converter TDC. The converter TDC comprises a pulse generator PGN, a register RG, a counter DCNT and a divider DV. The pulse generator PGN receives the event signal EVT from the comparator CP1 and the clock signal IFck and provides the stop signal SPI and a pulsed signal TDi to a load input LD of the register and to the counter DCNT. The counter DCNT receives a clock signal HSck of high frequency which can be generated by the controller CTL3 of the ADC CV3. The counter DCNT provides a count value DC to a data input of the register RG and to the divider DV. The divider DV comprises another input connected to the register RG and an output providing the output value TD of the converter TDC.

Figure 10 illustrates the operation of the ADC CV3. Figure 10 shows the control signal CS that controls the ADC, the reset signal RST, the clock signal IFck, the output voltage Vi of the operational amplifier OP1, the reference voltages Vrf, Vth, the output signal EVT of the comparator CP1, and the output signals TDi and SPI of the generator PGN, the clock signal HSck, the output DC of the counter DCNT and the content of the register RG. The control signal CS defines an initialization phase INT, an integration phase CVS, a conversion phase TDP and reading phase RDO. The signals CS, RST, IFck, Vi, EVT, SPI and ICNT are substantially the same as in Figure 7. The signals TDi, HSck are in a low state and values DC and RG are equal to 0 during the phases INT and CVS.

The integration is extended during the conversion phase TDP, to measure the voltage residue of the integration capacitor CI in time domain, but the counter ICNT is disabled. The clock signal IFck is set to its low state at the beginning of the conversion phase TDP. At this time, the pulse generator PGN generates a first pulse of duration Ta and ending at the occurrence of a first pulse in the signal EVT after the beginning of the conversion phase TDP. Then the pulse generator PGN generates a second pulse of duration Te and ending at the occurrence of a second pulse in the signal EVT after the beginning of the conversion phase TDP. The pulse duration Ta is measured by the counter DCNT and the counted value TA is stored in the register RG. The pulse duration Te is further measured by the counter DCNT and the counted value TE is provided to the divider DV with the content TA of the register RG. The signal TDi provided by the pulse generator PGN to the counter DCNT act as an enable signal of the counter DCNT. As long as a pulse (Ta or Te) is present, the counter DCNT is increased at each pulse of the clock signal HSck. Therefore, the counter values TA and TE correspond respectively to the time duration Ta, Te divided by the period of the clock signal HSck. The resolution of the measures TA and TE is equal to the period of the clock signal HSck. The divider DV provides the ratio R = TA/TE. Finally, the quantity $(1 - R) * 2^{TNB}$ defines the LSB of the count value DO and the LSBs of the conversion result, TNB being the number of bits of the counter TCNT.

The frequency of the clock signal HSck is at least five times and the frequency of the event signal EVT to measure the time intervals Tr or Ta and Te with a sufficient resolution. Indeed, the ratio of the frequencies of the signals HSck and EVT determines what the resolution of the circuit TDC, TDC1. Since the frequency of the signal EVT depends on the input signal (it is lower when the input signal is smaller), this means that the resolution of the circuit TDC, TDC1 is higher for lower input currents. Thus, the resolution improvement can be calculated as log2(1/2*Te_max/THSck), where Te_max is the period reached when the input current is maximum, and THSck is the period of the clock signal HSck. The factor 1/2 appears because two measurements (Ta and Te) are performed, doubling the error. The above equation can also be expressed as log2(TE/2). In fact, when the input signal is maximum, TE reached its minimum value and thus can be used to calculate resolution.

The final result FCR of the converter CV4 can be obtained by shifting right (toward the MSB) the count DO provided by the counter ICNT by the number of bits TNB of the range of the count value TD provided by the converter TDC1, and adding the count value TD to the shifted value.

The above description of various embodiments is provided for purpose of description to one of ordinary skills in the related art. It is not intended to be exhaustive or to limit the scope of the present disclosure solely to the disclosed embodiments. Numerous alternatives or variations to the present disclosure will be apparent to those of ordinary skills in the related art. Accordingly, while some alternatives or embodiments have been presented specifically, other embodiments will be apparent or easily developed by those of ordinary skills in the related art. Limitations in the appended claims should be interpreted broadly based on the language used in the claims and such limitations should not be restricted to the specific examples described above.

In this respect, it is apparent to those of ordinary skills in the related art that the noise signal to which the reset capacitor CR is submitted can be produced by any other ways than an operational amplifier (OP2).

Other ways than a counter to measure the residual time may be implemented. For example, at the end of the integration period, the input signal Ic is disconnected. At this point there is a voltage residue in the capacitor. Then, a known constant current source Vis is connected to the input of the integrator to keep the capacitor CI discharging. The converter TDC uses a counter to measure the time Ta between the instant when the current source is enabled and the next event in the event signal EVT. Thus the count value TA can be obtained. Then, the duration of the interval from this event and the next event is also measured to obtain the count value TE.

The residual charge in the integration capacitor may correspond to more than one bit of the event count value DO. This case may arise if the integration capacitor CI is not reset when the stored voltage Vi reaches the threshold Vcr. In this case, the integration continues beyond the threshold and the residual charge in the capacitor CI will correspond to more than the least significant bit of the count value DO.

In addition, the use of the capacitor CR is optional, and the integration capacitor can be alternatively initialized by connecting its terminals together using a controlled switch.

**Claims**

1. A method for converting an input analog signal into an output digital value, the method comprising, during an integration phase (CVS):

> applying an input analog signal (Ic) to an input of an integrator (OP1-CI) comprising an integration capacitor (CI) connected between the input and an output of the integrator;
> submitting a reset capacitor (CR) to a first reference voltage (Vth);
> each time a voltage (Vi) of the integrator output reaches a second reference voltage (Vrf-Vth), triggering a reset period from which an event in an event signal (EVT) is generated, the integration capacitor is coupled to the reset capacitor to reset the charge of the integration capacitor and the reset capacitor is submitted to a noise signal (Vn1) generated by the integrator; and
> counting the generated events in the event signal during the integration phase to obtain a digital value (DO) corresponding to the input analog signal.

2. The method of claim 1, wherein the reset capacitor (CR) is submitted to the first reference voltage (Vth) by coupling a first terminal of the reset capacitor to the second reference voltage (Vrf-Vth), a second terminal of the reset capacitor being connected to an output and a first input of an operational amplifier (OP2), a third reference voltage (Vrf) being provided to a second input of the first operational amplifier.

3. The method according to claim 1 or 2, wherein the reset capacitor (CR) is coupled to the integration capacitor (CI) by coupling a first terminal of the reset capacitor and a second input of an operational amplifier (OP2) to a first terminal of the integration capacitor (CI) and to the input of the integrator, a second terminal of the reset capacitor being connected to an output and a first input of the operational amplifier

4. The method according to one of claims 1 to 3, wherein a comparator (CP1) compares the integrator output voltage (Vi) to the second reference voltage (Vrf-Vth) and generates an event in the event signal (EVT) each time the integrator output voltage reaches the second reference voltage, and a counter (ICNT) counts the events in the event signal.

5. The method according to one of claims 1 to 4, further comprising:

> generating a first control signal (F1) controlling a first pair of switches (SW1, SW3) for submitting the reset capacitor (CR) to a first reference voltage (Vth) and a noise signal (Vn2); and

generating a second control signal (F2) controlling a second pair of switches (SW2, SW4) for coupling the integration capacitor (CI) to the reset capacitor to reset the charge of the integration capacitor, the first and second control signals being generated so as to have different logical states.

6. The method according to one of claims 1 to 5, further comprising:

at the end of the integration period, continuing to apply the input analog signal to the integrator, to couple the integration capacitor (CI) to the reset capacitor (CR) and to generate an event in the event signal (EVT), each time the output voltage of the integrator reaches the second reference voltage (Vrf-Vth);

determining a residual time (Tr) from a last event in the event signal to the end of the integration period; and

determining an output digital value corresponding to the input analog signal as a function of the event count value (DO), the residual time and an event period (Te).

7. The method according to claim 6, wherein:

the residual time (Tr) is measured by a counter providing a residual time count (TR), or

the residual time (Tr) is determined by measuring a time (Ta) from the end of the integration period (Ti) to a time when the integrator voltage (Vi) reaches the reference voltage (Vcr), and by subtracting the measured time (TA) from a measured event period (TE) to obtain a residual time count (TR).

8. The method according to claim 6 or 7, wherein the event period (Te) is measured between first and second consecutive events generated when the integrator voltage (Vi) reaches the reference voltage (Vcr) after the end of the integration period (Ti).

9. The method according to claim 8, wherein the output digital value (FCR) corresponding to the input analog signal (Ic) is determined from the event count value (DO) and a ratio (TD) of the residual time count (TR) and the measured event period (TE), a least significant bit of the count value having a fractional value equal to the ratio.

10. An analog-to-digital converter comprising:

an integrator (OP1-CI) comprising an integrator capacitor (CI) connected between an input and an output of the integrator, an input analog signal (Ic) to be converted being applied to the input of the integrator;

a reset capacitor (CR);

a comparator (CP1) configured to compare a voltage (Vi) of the integrator output to a second reference voltage (Vrf-Vth) and to generate an event in an event signal (EVT);

a counter (ICNT) configured to count the generated events in the event signal during an integration phase to obtain a digital value (DO) corresponding to the input analog signal; and

a control unit (CU) configured to control charge and discharge of the integration capacitor and the reset capacitor according to the method of one of claims 1 to 9.

11. The converter of claim 10, wherein the integrator comprises an operational amplifier (OP1) having a first input connected to the input (Ic) of the integrator, a second input receiving the third reference voltage (Vrf) and an output connected to the output of the integrator.

12. The converter according to claim 10 or 11, further comprising:

an operational amplifier (OP2) having a first input and an output connected to the first input and to a terminal of the reset capacitor (CR), a second input of the operational amplifier receiving a third reference voltage (Vrf) during the integration periods and being connected to the input of the integrator (OP1-CI) during the reset periods.

13. The converter according to one of claims 10 to 12, further comprising:

a first pair of switches (SW1, SW3) configured to submit the reset capacitor (CR) to a first reference voltage (Vth) during the integration periods, the first pair of switches being controlled by a first control signal (F1),

a second pair of switches (SW2, SW4) configured, during the reset periods, to submit the reset capacitor to the noise signal (Vn1) generated by the integrator (OP1, CI), and to couple the reset capacitor (CR) to the integration capacitor (CI), to reset the charge of the integration capacitor, the second pair of switches being controlled by a second control signal (F2), and

a logical circuit (I1, NG1, NG2) for generating the first and second control signals (F1, F2) such that the first and second control signals have different logical states.

14. The converter according to one of claims 10 to 13, further comprising a converter (TDC) receiving the event signal (EVT) and configured to measure a residual time (Te) corresponding to a residual charge left in the capacitor (CI) of the integrator at the end of the integration phase.

Prior Art
Fig. 1

Fig. 2

Fig. 3A

Fig. 3B

Fig. 4

Fig. 5A

Fig. 5B

Fig. 6

Fig. 7

Fig. 8

Fig. 9

Fig. 10

Europäisches
Patentamt

European
Patent Office

Office européen
des brevets

# EUROPEAN SEARCH REPORT

**Application Number**

EP 24 30 5470

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | MARGARIT J. M. ET AL: "A novel DPS integrator for fast CMOS imagers", 2008 IEEE INTERNATIONAL SYMPOSIUM ON CIRCUITS AND SYSTEMS (ISCAS), 18 May 2008 (2008-05-18), pages 1632-1635, XP093201398, Seattle, WA, USA DOI: 10.1109/ISCAS.2008.4541747 Retrieved from the Internet: URL:https://ieeexplore.ieee.org/stampPDF/g etPDF.jsp?tp=&arnumber=4541747&ref=aHR0cHM 6Ly9pZWVleHBsb3JlLmllZWUub3JnL2Fic3RyYWN0L 2RvY3VtZW50LzQ1NDE3NDc/Y2FzYV90b2tlbj1oMmZ vRS1OOHc5c0FBQUFBOkdRRXhhZWlxM25mZDRENkFFN E9HU2xDTFMa2ItRHpHS243243bjlEbnJTZHdmeFVFRU1 RVENDZUFGGUUZ5QkE3UURQUGsyaTN3QQ==> | 1,4-11, 14 | INV. H03M1/60 H03M3/00 H03M1/06 |
| A | * Section III; figures 2-6 * | 2,3,12, 13 | |
| X | DEI MICHELE ET AL: "Highly linear integrate-and-fire modulators with soft reset for low-power high-speed imagers", 2017 IEEE INTERNATIONAL SYMPOSIUM ON CIRCUITS AND SYSTEMS (ISCAS), IEEE, 28 May 2017 (2017-05-28), pages 1-4, XP033156074, DOI: 10.1109/ISCAS.2017.8050411 [retrieved on 2017-09-25] | 1,4-11, 14 | **TECHNICAL FIELDS SEARCHED (IPC)** H03M |
| A | * Section IV; figures 1,4,5 * | 2,3,12, 13 | |

The present search report has been drawn up for all claims

| Place of search | Date of completion of the search | Examiner |
|---|---|---|
| The Hague | 7 October 2024 | Jesus, Paulo |

EPO FORM 1503 03.82 (P04C01)